# EUROPÄISCHE PATENTSCHRIFT

(11) **EP 1 055 355 B1**
(45) Veröffentlichungstag und Bekanntmachung des Hinweises auf die Patenterteilung: **05.12.2001**
(21) Anmeldenummer: 99934222.3
(22) Anmeldetag: 25.01.1999
(51) Int. Cl.: H05K 3/38

(54) **VERFAHREN ZUM VORBEHANDELN VON KUPFEROBERFLÄCHEN**
PROCESS FOR THE PRELIMINARY TREATMENT OF COPPER SURFACES
PROCEDE DESTINE AU PRETRAITEMENT DE SURFACES DE CUIVRE

(30) Priorität: 03.02.1998 DE 19806190; 26.06.1998 DE 19830037
(43) Veröffentlichungstag der Anmeldung: 29.11.2000
(73) Patentinhaber: ATOTECH Deutschland GmbH, 10553 Berlin (DE)
(72) Erfinder: Grieser, Udo, 13599 Berlin (DE); Meyer, Heinrich, 14109 Berlin (DE); Hauf, Uwe, State College, PA 16803 (US)
(74) Vertreter: Effert, Bressel und Kollegen
(86) Internationale Anmeldenummer: DE9900244
(87) Internationale Veröffentlichungsnummer: WO9940765

(56) Entgegenhaltungen:
- EP-A- 0 670 379
- WO-A-96/19097
- US-A- 3 645 772
- PATENT ABSTRACTS OF JAPAN vol. 96, no. 8, 30. August 1996 & JP 08 097559 A (OKUNO CHEM IND CO), 12. April 1996 in der Anmeldung erwähnt

## Beschreibung

Die Erfindung betrifft ein Verfahren zum Vorbehandeln von Kupferoberflächen zum nachfolgenden Bilden eines haftfesten Verbundes zwischen den vorbehandelten Kupferoberflächen und Kunststoffsubstraten. Die Lösung dient vorzugsweise zum Vorbehandeln von Kupferschichten aufweisenden Leiterplatteninnenlagen zum Zweck der nachfolgenden Bildung eines haftfesten Verbundes zwischen den Leiterplatteninnenlagen und Leiterplatten-Kunstharzinnenlagen sowie zum Vorbehandeln von Kupferschichten aufweisenden Leiterplatten zum haftfesten Verbinden der Kupferschichten mit aus Kunststoffen bestehenden Resisten.

Bei der Herstellung von Leiterplatten werden verschiedene Teilprozesse durchgeführt, bei denen Kupferoberflächen haftfest an ein organisches Substrat gebunden werden müssen. In einigen Fällen muß die geforderte Haftfestigkeit der gebildeten Verbindungen auch über einen sehr langen Zeitraum gewährleistet sein. In anderen Fällen muß eine haftfeste Verbindung nur zeitweilig bestehen, beispielsweise wenn das organische Substrat nur während des Herstellprozesses der Leiterplatte auf den Kupferoberflächen verbleibt. Beispielsweise muß die haftfeste Verbindung von Trockenfilmresisten, die zur Strukturierung der Leiterzüge auf Leiterplatten dienen, mit den Kupferoberflächen nur während des Leiterplattenherstellverfahrens gewährleistet sein. Nach der Bildung der Leiterzugstrukturen können die Resiste wieder entfernt werden.

Die einfachste Möglichkeit zur Erhöhung der Haftfestigkeit besteht darin, die Kupferoberflächen vor dem Bilden der Verbindung anzuätzen und dabei aufzurauhen. Hierzu werden Mikroätzlösungen. beispielsweise schwefelsaure Lösungen von Wasserstoffperoxid oder Natriumperoxodisulfat, verwendet.

Ein weiteres Verfahren ist in US-A-3,645,772 beschrieben. Danach wird eine Vorbehandlungslösung für die Kupferoberflächen verwendet, die beispielsweise 5-Aminotetrazol enthält.

Eine Langzeitstabilität ist insbesondere beim Laminierprozeß für Mehrlagenleiterplatten erforderlich. Für diese Zwecke sind andere Vorbehandlungsverfahren für die Kupferoberflächen erforderlich.

Bei der Herstellung von Mehrlagenleiterplatten werden mehrere Leiterplatteninnenlagen zusammen mit isolierenden Kunstharzlagen (sogenannte prepregs:
mit Glasfasernetzen verstärkte Epoxidharzfolien) laminiert. Der innere Zusammenhalt eines Laminats muß während der gesamten Lebensdauer der Leiterplatte aufrechterhalten bleiben. Hierzu müssen die auf den Innenlagen aufliegenden Kupferschichten, vorzugsweise die Leiterzugstrukturen, oberflächlich behandelt werden. Um dieses Problem zu lösen, wurden verschiedene Verfahren entwickelt.

Das für die Vorbehandlung der Materialien vor dem Laminierverfahren üblicherweise angewendete Verfahren besteht darin, eine Oxidschicht auf den Kupferoberflächen zu bilden. Bei diesem als Schwarz- oder Braunoxidverfahren bekannten Prozeß werden sehr aggressive Reaktionsbedingungen zur Oxidbildung eingestellt. Ein Nachteil des Verfahrens besteht darin, daß die die Haftfestigkeit zur Kunstharzlage vermittelnde Oxidschicht nur eine geringe Beständigkeit gegen saure, insbesondere salzsaure, Behandlungslösungen aufweist, so daß sie bei Nachfolgeprozessen zur Metallisierung der Durchgangsbohrungen in Leiterplatten angegriffen und der Haftverbund unter Bildung von Delaminationen an den angegriffenen Stellen wieder aufgehoben wird (pink ring-Phänomen: von außen sichtbarer Angriff der Schwarzoxidschicht in unmittelbarer Umgebung eines Loches in Leiterplatten durch Verfärbung der ursprünglich schwarzen Oxidschicht, bei der die rosafarbene Kupferschicht der Innenlage als ringförmiger Defekt erkennbar wird; wedge void-Phänomen: in einem durch eine behandelte Bohrung in Leiterplatten angefertigten Querschliff erkennbarer Defekt in Form einer Spaltbildung zwischen einer Kupferinnenlage und dem angrenzenden Leiterplattenharz durch den Angriff von sauren Behandlungslösungen auf die Schwarzoxidschicht).

Eine Lösung des vorstehend beschriebenen Problems besteht darin, die Oxidschicht vor dem Laminierprozeß oberflächlich zu reduzieren. Das reduzierte Schwarzoxid weist gegenüber den bei der Durchkontaktierung der Durchgangslöcher verwendeten Chemikalien eine höhere Stabilität auf als normales Schwarzoxid. Durch den zusätzlichen Reduktionsschritt werden jedoch erhebliche Kosten verursacht. Zudem sind die für die Reduktionsbehandlung verwendbaren Chemikalien gegen Oxidation durch Luft wenig beständig, so daß die Standzeit der Bäder und die Haltbarkeit der Ergänzungschemikalien begrenzt sind. Dieses Problem soll nach JP-A-08097559 dadurch behoben werden, daß die reduzierten Kupferoxidschichten anschließend mit einer Schutzschicht versehen werden, indem diese mit einer wäßrigen Lösung behandelt werden, in der eine Aminothiazol- und/oder Aminobenzothiazol-Verbindung enthalten ist. Jedoch kann damit zum einen das Kostenproblem der teuren Reduktionschemikalien und deren mangelnde Oxidationsbeständigkeit und zum anderen auch die Säureinstabilität der Schicht nicht vollständig behoben werden.

Eine andere Möglichkeit zur Haftvermittlung besteht darin, die Kupferoberflächen mit einer wäßrigen oder alkoholischen Lösung einer Azolverbindung zu behandeln. Ein derartiges Verfahren ist beispielsweise aus WO 96/19097 A1 bekannt. Danach werden die Kupferoberflächen mit einer Lösung behandelt, in der 0,1 bis 20 Gew.-% Wasserstoffperoxid, eine anorganische Säure, beispielsweise Schwefelsäure, ein organischer Korrosionsinhibitor, beispielsweise Benzotriazol, und ein Netzmittel enthalten sind. Durch die Ätzwirkung von Wasserstoffperoxid werden die Kupferoberflächen angeätzt, so daß mikrorauhe Oberflächen entstehen.

Auch aus US-A-4,917,758 sind Ätzlösungen bekannt, die jedoch zum Abdünnen von Kupferkaschierungen auf den Leiterplattenmaterialien dienen. In diesen Lösungen sind ebenfalls Wasserstoffperoxid, Schwefelsäure sowie eine Stickstoff enthaltende Verbindung, vorzugsweise Aminobenzoesäure. Aminotetrazol oder Phenylharnstoff, enthalten.

Der vorliegenden Erfindung liegt von daher das Problem zugrunde, die Nachteile des Standes der Technik zu vermeiden und insbesondere ein Vorbehandlungsverfahren zu finden, mit dem eine Verbindung von Kupferoberflächen zu Kunststoffoberflächen mit exzellenter Haftfestigkeit des Verbundes hergestellt werden kann. Das Verfahren soll einfach, sicher in der Handhabung und billig sein. Außerdem sollen sich in den Behandlungslösungen keine Ausfällungen bilden. Es ist ferner wichtig, daß durch Behandlung mit der Lösung auch eine Materialverbindung erhältlich ist, die bei Nachfolgeprozessen beim Herstellen von Leiterplatten, beispielsweise bei der Metallisierung von Durchgangsbohrungen in Leiterplattenmaterial, nicht zu Problemen führt (pink ring-, wedge void-Bildung). Vorzugsweise sollen die verwendeten Vorbehandlungslösungen daher für die Anwendung beim Leiterplattenherstellverfahren einsetzbar sein.

Gelöst wird dieses Problem durch das Verfahren gemäß Anspruch 1.

Das erfindungsgemäße Verfahren dient zum Vorbehandeln von Kupferoberflächen zum nachfolgenden Bilden eines haftfesten Verbundes mit Kunststoffsubstraten. Hierzu werden die Kupferoberflächen aufweisenden Substrate, beispielsweise Kupferfolien oder mit Kupferfolien überzogene Harziaminate, mit einer ersten Lösung in Kontakt gebracht, die folgende Bestandteile enthält:
a. Wasserstoffperoxid,
b. mindestens eine Säure und
c. mindestens eine Stickstoff enthaltende, fünfgliedrige heterocyclische Verbindung, die kein Schwefel-, Selen- oder Telluratom im Heterocyclus aufweist.

Danach werden die die Kupferoberflächen aufweisenden Substrate mit einer zweiten Lösung in Kontakt gebracht, die mindestens eine haftvermittelnde Verbindung aus der Gruppe, bestehend aus Sulfinsäuren, Seleninsäuren. Tellurinsäuren, heterocyclischen Verbindungen, die mindestens ein Schwefel-. Selen- und/oder Telluratom im Heterocyclus enthalten, sowie Sulfonium-, Selenonium- und Telluroniumsalzen enthält, wobei die Sulfonium-, Selenonium- und Telluroniumsalze Verbindungen mit der allgemeinen Formel **A** sind 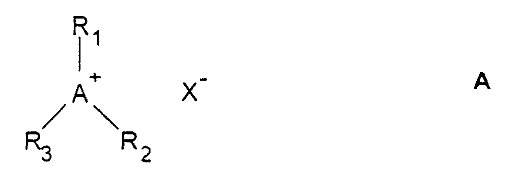 wobei
A = S, Se oder Te,
R₁, R₂ und R₃ = Alkyl, substituiertes Alkyl, Alkenyl, Phenyl, substituiertes Phenyl, Benzyl, Cycloalkyl, substituiertes Cycloalkyl, wobei R₁, R₂ und R₃ gleich oder unterschiedlich sind, und
X⁻ = Anion einer anorganischen oder organischen Säure oder Hydroxid.

Es sollen haftvermittelnde Verbindungen ausgewählt werden, die in der sauren, vorzugsweise schwefelsauren, Lösung eine ausreichende Löslichkeit aufweisen.

Das der Erfindung zugrunde liegende Problem wird insbesondere auch durch die Anwendungsmöglichkeiten des Verfahrens nach den Ansprüchen 18 und 19 gelöst. Danach dient das erfindungsgemäße Verfahren vorzugsweise zum Vorbehandeln von Kupferschichten aufweisenden Leiterplatteninnenlagen zum Bilden eines hartfesten Verbundes zwischen den Leiterplatteninnenlagen und Kunstharzlagen sowie zum Vorbehandeln von Kupferschichten aufweisenden Leiterplatten zum Bilden eines haftfesten Verbundes zwischen den Kupferschichten und aus Kunststoffen bestehenden Resisten.

Bevorzugte Ausführungsformen der Erfindung sind in den Unteransprüchen angegeben.

Bevorzugte Sulfinsäuren in der zweiten Lösung sind haftvermittelnde Verbindungen mit der chemischen Formel **B** 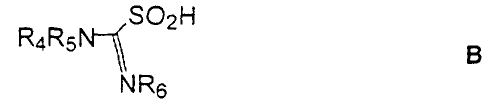
- mit R₄, R₅ und R₆ =: Wasserstoff, Alkyl, substituiertes Alkyl, Phenyl, substituiertes Phenyl oder R₇-(CO)- mit R₇ = Wasserstoff, Alkyl, substituiertes Alkyl, Phenyl, substituiertes Phenyl, wobei R₄, R₅ und R₆ gleich oder unterschiedlich sind,
und aromatische Sulfinsäuren.

Vorzugsweise ist Formamidinsulfinsäure als haftvermittelnde Verbindung in der zweiten Lösung enthalten. Als aromatische Sulfinsäuren können bevorzugt Benzolsulfinsäure, Toluolsulfinsäuren, Chlorbenzolsulfinsäuren, Nitrobenzolsulfinsäuren und Carboxybenzolsulfinsäuren eingesetzt werden.

Als haftvermitteinde heterocyclische Verbindungen werden vorzugsweise Thiophene, Thiazole, Isothiazole, Thiadiazole und Thiatriazole eingesetzt.

### Geeignete Thiophene sind Verbindungen mit der chemischen Formel C

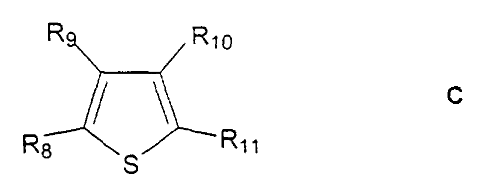

- mit R₈, R₉, R₁₀, R₁₁=: Wasserstoff, Alkyl, substituiertes Alkyl, Phenyl, substituiertes Phenyl, Halogen, Amino, Alkylamino, Dialkylamino, Hydroxy, Alkoxy, Carboxy, Carboxyalkyl, Alkoxycarbonyl, Aminocarbonyl, R₁₂-CONH- mit R₁₂ = Wasserstoff, Alkyl, substituiertes Alkyl, Phenyl oder substituiertes Phenyl, wobei R₈, R₉, R₁₀ und R₁₁ gleich oder unterschiedlich und Teil von an den Thiophenring kondensierten homo- oder heterocyclischen Ringen sein können.

Besonders bevorzugte Thiophene sind Aminothiophencarbonsäuren, deren Ester und Amide. Beispielsweise kann 3-Aminothiophen-2-carbonsäuremethylester vorteilhaft eingesetzt werden.

### Geeignete Thiazole sind Verbindungen mit der chemischen Formel D:

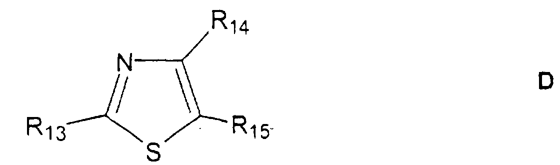

- mit R₁₃, R₁₄, R₁₅ =: Wasserstoff, Alkyl, substituiertes Alkyl, Phenyl, substituiertes Phenyl, Halogen, Amino, Alkylamino, Dialkylamino, Hydroxy, Alkoxy, Carboxy, Carboxyalkyl, Alkoxycarbonyl, Aminocarbonyl, R₁₆-CONH- mit R₁₆ = Wasserstoff, Alkyl, substituiertes Alkyl, Phenyl oder substituiertes Phenyl, wobei R₁₃, R₁₄ und R₁₅ gleich oder unterschiedlich und Teil eines an den Thiazolring kondensierten homo- oder heterocyclischen Ringes sein können.

Besonders geeignete Thiazole sind Aminothiazol sowie substituierte Aminothiazole. Ferner sind bevorzugte Thiadiazole haftvermittelnde Verbindungen aus der Gruppe, bestehend aus Aminothiadiazolen und substituierten Aminothiadiazolen.

Ferner werden als Sulfoniumsalze vorzugsweise Trimethylsulfonium-, Triphenylsulfonium-, Methioninalkylsulfonium- und Methioninbenzylsulfoniumsalze als haftvermittelnde Verbindungen, die in der zweiten Lösung enthalten sind, eingesetzt.

Zusätzlich zu den vorgenannten Verbindungen sind in der zweiten Lösung weitere Bestandteile enthalten. Vorzugsweise enthält die zweite Lösung ebenso wie die erste Lösung auch eine Säure, vorzugsweise eine anorganische Säure und besonders bevorzugt Schwefelsäure. Außerdem können in der zweiten Lösung Kupferionen enthalten sein, die beispielsweise auch durch Auflösung von Kupfer an den behandelten Kupferoberflächen entstehen.

In der ersten Lösung sind neben Wasserstoffperoxid und einer Säure zusätzlich Stickstoff enthaltende, fünfgliedrige heterocyclische Verbindungen enthalten, die kein Schwefel-, Selen- oder Telluratom im Heterocyclus enthalten. Es können monocyclische und polycyclische kondensierte Ringsysteme als heterocyclische Verbindungen eingesetzt werden. Beispielsweise können die Verbindungen anellierte Benzol-, Naphthalin- oder Pyrimidinringe enthalten. Für die Auswahl dieser Verbindungen ist zu beachten, daß diese in der sauren Lösung eine ausreichende Löslichkeit aufweisen sollen. Vorzugsweise sind Triazole, Tetrazole, Imidazole, Pyrazole und Purine bzw. deren Derivate in der Lösung enthalten.

Die erste Lösung enthält insbesondere Triazole mit der chemischen Formel **E1** als heterocyclische Verbindungen 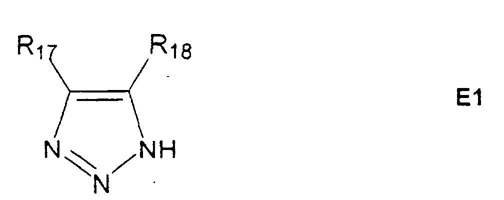
- mit R₁₇, R₁₈ =: Wasserstoff, Alkyl, substituiertes Alkyl, Amino, Phenyl, substituiertes Phenyl, Carboxyalkyl, wobei R₁₇ und R₁₈ gleich oder unterschiedlich und Teil eines an den Triazolring kondensierten homo- oder heterocyclischen Ringes sein können.

Besonders bevorzugte heterocyclische Verbindungen in der ersten Lösung sind Benzotriazol, Methylbenzotriazol, Ethylbenzotriazol und Dimethylbenzotriazol.

Außerdem kann die erste Lösung Tetrazole mit der chemischen Formel **E2** als haftvermittelnde Verbindungen enthalten 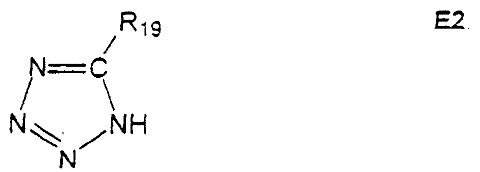
- mit R₁₉ =: Wasserstoff, Alkyl, substituiertes Alkyl, Halogenalkyl, Amino, Phenyl, substituiertes Phenyl, Benzyl, Carboxy, Carboxyalkyl, Alkoxycarbonyl, Aminocarbonyl oder R₂₀-CONH mit R₂₀ = Wasserstoff, Alkyl, substituiertes Alkyl, Phenyl oder substituiertes Phenyl.

Als bevorzugte Tetrazolverbindung werden 5-Aminotetrazol und 5-Phenyltetrazol eingesetzt. Als bevorzugte Imidazolverbindung wird Benzimidazol verwendet. 5-Aminotetrazol, 5-Phenyltetrazol, Benzotriazol, Methylbenzotriazol und Ethylbenzotnazol sind insbesondere wegen deren guter Löslichkeit in der ersten Vorbehandlungslösung und wegen der leichten Verfügbarkeit bevorzugte Verbindungen.

Bevorzugte Kombinationen sind Benzotriazol, Methylbenzotriazol, Ethylbenzotriazol, 5-Aminotetrazol und 5-Phenyltetrazol als Stickstoff enthaltende, fünfgliedrige heterocyclische Verbindungen in der ersten Lösung mit Aminothiophencarbonsäuren, deren Estem und Amiden, Aminothiazol und substituierten Aminothiazolen als heterocyclische Verbindungen in der zweiten Lösung.

Außerdem enthält die erste Lösung im allgemeinen Kupferionen, die sich durch Anätzen der Kupferoberflächen bilden und in der Lösung anreichern.

Das erfindungsgemäße Verfahren stellt eine außerordentlich einfache Vorbehandlung von Kupferoberflächen für die nachfolgende haftfeste Verbindung mit Kunststoffen sicher. Im wesentlichen sind lediglich zwei Verfahrensschritte erforderlich, nämlich die Behandlung der Kupferoberflächen mit der ersten und der zweiten Lösung zur nachfolgenden Bildung eines Verbundes mit organischen Substraten. Die Haftfestigkeit sinkt auch nach langer Zeit nicht ab.

Sind in der ersten Lösung die Stickstoff enthaltenden, heterocyclischen Verbindungen nicht enthalten oder in der zweiten Lösung die haftvermitteinden Verbindungen nicht enthalten, kann keine annähernd so hohe Haftfestigkeit des Verbundes erreicht werden. Außerdem ist die Langzeitstabilität des Verbundes nach Vorbehandlung mit Lösungen, die die haftvermitteinden Verbindungen nicht enthalten, wesentlich schlechter als nach Verwendung von Lösungen, die die haftvermitteinden Verbindungen enthalten.

Darüber hinaus werden die im Zusammenhang mit der Metallisierung von Durchgangslöchern in Leiterplatten entstehenden Probleme. nämlich die Bildung von pink ring und wedge voids, durch den Einsatz dieser zusätzlichen Verbindungen in den Vorbehandlungslösungen vermieden, da die mit dem erfindungsgemäßen Verfahren erzeugten haftvermittelnden Schichten eine ausgezeichnete Säurebeständigkeit aufweisen, während Black Oxide-(Schwarzoxid-) und reduzierte Black Oxide-Schichten gegen salzsaure Lösungen eine gewisse Empfindlichkeit aufweisen. Es hat sich sogar gezeigt, daß sich die Haftfestigkeit eines Verbundes mit organischen Substraten in bestimmten Fällen noch weiter verbessem läßt, wenn die Kupferoberflächen nach dem Behandeln mit dem erfindungsgemäßen Verfahren und vor dem Herstellen des Verbundes mit verdünnter Säure behandelt werden. Vorzugsweise kann hierfür Salzsäure eingesetzt werden. Außerdem ist das Verfahren weitgehend beständig gegen Ausfällungen.

Die vorteilhafte Wirkung des erfindungsgemäßen Verfahrens war überraschend, da auch eine alleinige Verwendung der haftvermittelnden Verbindungen in einer der Vorbehandlungslösungen ohne Anwendung der Stickstoff enthaltenden, fünfgliedrigen heterocyclischen Verbindungen in der anderen Lösung nicht die erwünschte hohe Langzeit-Haftfestigkeit ergibt. Durch Anwendung sowohl der Stickstoff enthaltenden, fünfgliedrigen heterocyclischen Verbindungen als auch der haftvermitteinden Verbindungen verfärben sich die Kupferoberflächen und führen zu den gewünschten Eigenschaften.

Zur sicheren Vorbehandlung werden die Kupferoberflächen in der Regel zuerst gereinigt. Hierzu können alle herkömmlichen Reinigungslösungen verwendet werden. Üblicherweise werden Netzmittel und gegebenenfalls Komplexbildner, beispielsweise Triethanolamin, enthaltende wäßrige Lösungen eingesetzt.

Nach dem Spülen der gereinigten Kupferoberflächen können diese mit einer sogenannten Vortauchlösung in Kontakt gebracht werden, die eine der fünfgliedrigen heterocyclischen Verbindungen (Komponente c.) in Wasser gelöst enthält, vorzugsweise in einer Konzentration von 0,1 bis 10 g/l, besonders bevorzugt von 0,5 bis 2 g/l. Durch diese Behandlung wird die haftvermitteinde Schicht im nachfolgenden Behandlungsschritt in zuverlässigerer Weise gebildet. Insbesondere werden eventuelle Verzögerungen der Schichtbildung vermieden; die Schichtbildung startet in diesem Falle unmittelbar mit dem In-Kontakt-Bringen der Oberflächen mit der Lösung.

Anschließend werden die Oberflächen ohne weitere Spülung in der ersten Lösung, enthaltend die Komponenten a., b. und c., behandelt. Danach können die Substrate gespült werden, um anhaftende Flüssigkeit von der Substratoberfläche zu entfernen. Anschließend folgt die Behandlung in der zweiten Lösung. Die Kupferoberflächen können jedoch auch unmittelbar nach der Behandlung mit der ersten Lösung ohne weiteren Spülschritt direkt mit der zweiten Lösung in Kontakt gebracht werden.

Bei dieser Behandlung verfärben sich die Kupferoberflächen unter Bildung einer haftvermittelnden Schicht von rosafarben in einen Braunton, je nach Art der eingesetzten Kombination von Stickstoff enthaltenden, fünfgiiedrigen heterocyclischen in der ersten Lösung und haftvermittelnden Verbindungen in der zweiten Lösung.

Durch die Mikroätzwirkung des Wasserstoffperoxids in Verbindung mit der Säure werden mikrorauhe Kupferoberflächen erhalten, die wegen der Oberflächenvergrößerung eine Erhöhung der Haftfestigkeit des nachfolgend gebildeten Verbundes zwischen den Kupferoberflächen und dem Kunststoffsubstrat ermöglicht. Die sich beim Behandeln ändernde Farbe der Oberflächen wird durch eine dünne Kupferoxidschicht hervorgerufen. Es wird außerdem vermutet, daß die Haftfestigkeit des nachfolgend gebildeten Verbundes zusätzlich durch die Bildung einer kupferorganischen Verbindung verbessert wird, die sich wahrscheinlich aus Kupfer bzw. Kupferoxid, der Stickstoff enthaltenden Verbindung und der haftvermittelnden Verbindung auf der Kupferoberfläche bildet.

Als Säure ist in der ersten Lösung vorzugsweise anorganische Säure, besonders bevorzugt Schwefelsäure, enthalten. Grundsätzlich sind aber auch andere Säuren einsetzbar.

Zur Stabilisierung von Wasserstoffperoxid gegen einen Zerfall kann die erste Lösung zusätzliche weitere Verbindungen, beispielsweise p-Phenoisulfonsäure, enthalten.

Als Lösungsmittel können beide Lösungen Wasser und zusätzlich organische Lösungsmittel, wie Alkohole, enthalten, beispielsweise um die Löslichkeit der darin enthaltenen Bestandteile, insbesondere der Stickstoff enthaltenden, fünfgliedrigen heterocyclischen Verbindungen bzw. der haftvermitteinden Verbindungen, zu erhöhen.

Zusätzlich können auch weitere anorganische und organische Verbindungen in den Lösungen enthalten sein, beispielsweise Netzmittel. Kupfersulfat kann auch in der zweiten Lösung enthalten sein.

Die Behandlung mit beiden Lösungen wird vorzugsweise bei einer Temperatur von 20 bis 60°C durchgeführt. Die Behandlungszeit beträgt bevorzugt 10 bis 600 Sekunden. Je höher die Temperatur eingestellt wird, desto schneller wirkt die Lösung. Daher können gegebenenfalls auch wesentlich kürzere Behandlungszeiten gewählt werden. Unter praktischen Gesichtspunkten wird jedoch vorzugsweise eine mittlere Temperatur gewählt, beispielsweise von 35 bis 45°C, um die Reaktion besser kontrollieren zu können. Mittlere Behandlungszeiten sind 20 bis 90 Sekunden. Außerdem kann sich wegen möglicher Inkompatibilitäten bestimmter Bestandteile der Lösung bei erhöhter Temperatur, beispielsweise wegen bei erhöhter Temperatur schlecht löslicher Netzmittel, das Erfordernis ergeben, eine obere Temperaturgrenze einzuhalten.

Die in den Lösungen bevorzugt eingestellten Konzentrationsbereiche sind:

| Erste Lösung: | |
|---|---|
| Schwefelsäure, konz. | 10 bis 250 g/l |
| Wasserstoffperoxid, 30 Gew.-% fünfgliedrige Stickstoff enthaltende | 1 bis 100 g/l |
| heterocyclische Verbindung | 0,5 bis 50 g/l |

| Zweite Lösung: | |
|---|---|
| Schwefelsäure, konz. | 10 bis 250 g/l |
| haftvermittelnde Verbindungen: Sulfin-, Selenin- und/oder Tellurinsäure | 0,05 bis 10 g/l |
| haftvermittelnde heterocyclische Verbindung | 0,05 bis 20 g/l |
| Sulfonium-, Selenonium- und/oder Telluroniumsalz | 0,01 bis 10 g/l |

Die optimalen Konzentrationen der vorgenannten Badbestandteile hängen von der Art der eingesetzten Stickstoff enthaltenden, heterocyclischen Verbindungen und der haftvermittelnden Verbindungen ab.

Nach der Behandlung mit dem erfindungsgemäßen Verfahren werden die Kupferoberflächen wieder gespült, vorzugsweise mit warmem, deionisiertem Wasser. Anschließend werden sie getrocknet, beispielsweise mit heißer Luft.

Optional können die Kupferoberflächen nach dem Spülen auch mit verdünnter Säure behandelt werden, vorzugsweise mit 10 Gew.-% Salzsäure oder 10 Gew.-% Schwefelsäure. Behandlungszeiten von 5 Sekunden bis 300 Sekunden sind dabei zweckmäßig. Nach der Säurebehandlung werden die Kupferoberflächen erneut gespült, vorzugsweise mit deionisiertem Wasser.

Zur Erhöhung der Haltbarkeit der ersten und der zweiten Lösung ist es günstig, die gebrauchsfertigen Behandlungslösungen kurz vor der Durchführung des Verfahrens anzusetzen. Beispielsweise kann zum Ansatz der ersten Lösung Wasserstoffperoxid mit einer schwefelsauren Lösung der Stickstoff enthaltenden, heterocyclischen Verbindung gemischt werden oder kurz vor dem Gebrauch eine bereits angesetzte Lösung ergänzt werden, um die gewünschten Konzentrationen der Einzelbestandteile einzustellen.

Die Behandlung der die Kupferoberflächen aufweisenden Werkstücke kann in üblichen Tauchanlagen durchgeführt werden. Bei der Behandlung von Leiterplatten hat es sich als besonders günstig herausgestellt, sogenannte Durchiaufanlagen einzusetzen, bei denen die Platten in einer horizontalen Transportbahn durch die Anlage geführt und dabei mit den Behandlungslösungen in Kontakt gebracht werden, indem die Platten durch ein Flüssigkeitsbett geführt werden, das durch am Anfang und am Ende der Behandlungsstrecke angeordnete Abquetschwalzen aufgestaut ist, und/oder indem die Platten über geeignete Düsen, beispielsweise Sprüh- oder Schwalldüsen, mit der Behandlungsflüssigkeit in Kontakt gebracht werden. Die Leiterplatten können hierzu horizontal oder vertikal oder in jeder beliebigen anderen Ausrichtung gehalten werden.

Die nachfolgenden Beispiele dienen zur weiteren Erläuterung der Erfindung:

### Beispiel 1:

Es wurden eine erste und eine zweite wäßrige Lösung durch Vermischen folgender Bestandteile hergestellt:

| Erste Lösung: | |
|---|---|
| Schwefelsäure, 96 Gew.-% | 50 ml |
| Wasserstoffperoxid, 30 Gew.-% in Wasser | 40 ml |
| Benzotrilazol | 10 g |
| Kupfer-(II)-sulfat-Pentahydrat Auffüllen mit deionisiertem Wasser auf 1 l | 62 g |

| Zweite Lösung: | |
|---|---|
| Schwefelsäure, 96 Gew.-% | 50 ml |
| 2-Aminothiazol | 8,0 g |
| Kupfer-(II)-sulfat-Pentahydrat Auffüllen mit deionisiertem Wasser auf 1 l | 62 g |

Beide Lösungen wurden auf 40°C erwärmt. Eine Kupferfolie (Leiterplattenqualität, etwa 25 µm Dicke) wurde zunächst 60 sec lang in die erste Lösung und dann ohne Zwischenspülung 60 sec lang in die zweite Lösung eingetaucht. Danach wurde die Folie mit warmem deionisiertem Wasser (50°C) gespült und mit warmer Luft getrocknet.

Die Kupferfolie wies nach der Behandlung einen hellbraunen Farbton auf.

Die Kupferfolie wurde danach auf ein prepreg (mit Glasfasernetz verstärkte Epoxidharzfolie (FR4-Harz), Type 2125 MT, Dicke 0,1 µm von Firma Dielektra, DE) laminiert, indem die Kupfer- und die Prepregfolie bei einer Temperatur von 175°C bei einem Druck von 2,5·10⁶ Pa (Δ 25 Bar) zusammen verpresst wurden.

Die Schälfestigkeit der Kupferfolie auf der Prepregfolie wurde gemessen. Es wurden Schälfestigkeiten von 10,7 bis 11,0 N/cm ermittelt.

### Beispiel 2:

Es wurden wiederum eine erste und eine zweite wäßrige Lösung durch Vermischen folgender Bestandteile hergestellt:

| Erste Lösung: | |
|---|---|
| Schwefelsäure, 96 Gew.-% | 50 ml |
| Wasserstoffperoxid, 30 Gew.-% in Wasser | 40 ml |
| Benzotriazol | 10 g |
| Kupfer-(II)-sulfat-Pentahydrat Auffüllen mit deionisiertem Wasser auf 1 l | 62 g |

| Zweite Lösung: | |
|---|---|
| Schwefelsäure, 96 Gew.-% | 50 ml |
| 2-Aminothiazol | 8,0 g |
| Benzottlazol | 10 g |
| Kupfer-(II)-sulfat-Pentahydrat Auffüllen mit deionisiertem Wasser auf 1 l | 12 g |

Beide Lösungen wurden auf 40°C erwärmt. Eine Kupferfolie (Leiterplattenqualität, etwa 25 µm Dicke) wurde zunächst 60 sec lang in die erste Lösung eingetaucht, dann mit deionisiertem Wasser gespült und anschließend 60 sec lang in die zweite Lösung eingetaucht. Danach wurde die Folie mit warmem deionisiertem Wasser (50°C) gespült und mit warmer Luft getrocknet

Die Kupferfolie wies nach der Behandlung einen hellbraunen Farbton auf.

Danach wurce die Folie mit einem prepreg verpresst (Bedingungen wie bei Beispiel 1) und die Schälfestigkeit des Verbundes gemessen. Es wurden Haftfestigkeitswerte von 9,8 bis 10,1 N/cm ermittelt.

## Patentansprüche

1. Verfahren zum Vorbehandeln von Kupferoberflächen zum nachfolgenden Bilden eines haftfesten Verbundes zwischen den Kupferoberflächen und Kunststoffsubstraten durch In-Kontakt-Bringen der Kupferoberflächen mit einer ersten Lösung, enthaltend
a. Wasserstoffperoxid,
b. mindestens eine Säure und
c. mindestens eine Stickstoff enthaltende, fünfgliedrige heterocyclische Verbindung, die kein Schwefel-, Selen- oder Telluratom im Heterocyclus aufweist,
**dadurch gekennzeichnet, daß**
die Kupferoberflächen danach mit einer zweiten Lösung, enthaltend
d. mindestens eine haftvermittelnde Verbindung aus der Gruppe, bestehend aus Sulfinsäuren, Seleninsäuren, Tellurinsäuren, heterocyclischen Verbindungen, die mindestens ein Schwefel-, Selen- und/oder Telluratom im Heterocyclus enthalten, sowie Sulfonium-, Selenonium- und Telluroniumsalzen, in Kontakt gebracht werden, wobei die Sulfonium-, Selenonium- und Telluroniumsalze Verbindungen mit der allgemeinen Formel **A** sind 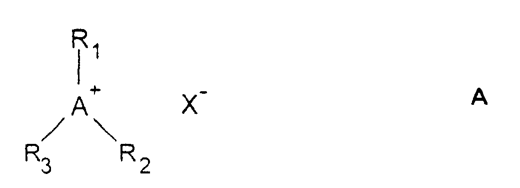 wobei
A = S, Se oder Te,
R₁, R₂ und R₃ = Alkyl, substituiertes Alkyl, Alkenyl, Phenyl. substituiertes Phenyl, Benzyl, Cycloalkyl. substituiertes Cycloalkyl, wobei R₁, R₂ und R₃ gleich oder unterschiedlich sind, und
X⁻ = Anion einer anorganischen oder organischen Säure oder Hydroxid.

2. Verfahren nach Anspruch 1, **dadurch gekennzeichnet, daß** Sulfinsäuren aus der Gruppe, bestehend aus aromatischen Sulfinsäuren und Verbindungen mit der chemischen Formel **B** 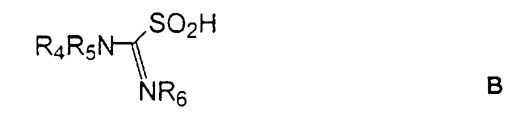
mit R₄, R₅ und R₆ = Wasserstoff, Alkyl, substituiertes Alkyl, Phenyl, substituiertes Phenyl, R₇-(CO)- mit R₇ = Wasserstoff, Alkyl, substituiertes Alkyl, Phenyl oder substituiertes Phenyl, wobei R₄, R₅ und R₆ gleich oder unterschiedlich sind,
als haftvermittelnde Verbindungen ausgewählt werden.

3. Verfahren nach einem der vorstehenden Ansprüche, **dadurch gekennzeichnet, daß** Formamidinsulfinsäure als haftvermittelnde Verbindung ausgewählt wird.

4. Verfahren nach einem der Ansprüche 1 und 2, **dadurch gekennzeichnet, daß** aromatische Sulfinsäuren aus der Gruppe, bestehend aus Benzolsulfinsäure, Toluolsulfinsäuren. Chlorbenzolsulfinsäuren, Nitrobenzolsulfinsäuren und Carboxybenzolsulfinsäuren, als haftvermittelnde Verbindungen ausgewählt werden.

5. Verfahren nach einem der vorstehenden Ansprüche, **dadurch gekennzeichnet, daß** mindestens eine heterocyclische Verbindung aus der Gruppe, bestehend aus Thiophenen, Thiazoien, Isothiazolen, Thiadiazolen und Thiatriazolen, als haftvermittelnde Verbindung ausgewählt wird.

6. Verfahren nach Anspruch 5, **dadurch gekennzeichnet, daß** mindestens ein Thiophen aus der Gruppe, bestehend aus Verbindungen mit der chemischen Formel C 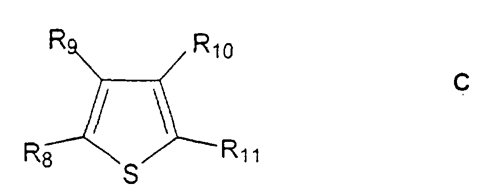
mit R₈, R₉, R₁₀, R₁₁ = = Wasserstoff, Alkyl, substituiertes Alkyl, Phenyl, substituiertes Phenyl, Halogen, Amino, Alkylamino, Dialkylamino, Hydroxy, Alkoxy, Carboxy, Carboxyalkyl, Alkoxycarbonyl, Aminocarbonyl, R₁₂-CONH- mit R₁₂ = Wasserstoff, Alkyl, substituiertes Alkyl, Phenyl oder substituiertes Phenyl, wobei R₈, R₉, R₁₀ und R₁₁ gleich oder unterschiedlich und Teil von an den Thiophenring kondensierten homo- oder heterocyclischen Ringen sein können,
als haftvermittelnde Verbindung ausgewählt wird.

7. Verfahren nach einem der Ansprüche 5 und 6, **dadurch gekennzeichnet, daß** mindestens ein Thiophen aus der Gruppe, bestehend aus Aminothiophencarbonsäuren, deren Estern und deren Amiden, als haftvermittelnde Verbindung ausgewählt wird.

8. Verfahren nach einem der Ansprüche 5 bis 7, **dadurch gekennzeichnet, daß** mindestens ein Thiazol aus der Gruppe, bestehend aus Verbindungen mit der chemischen Formel **D** 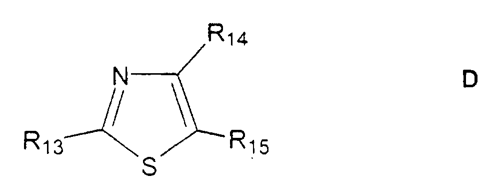
mit R₁₃, R₁₄, R₁₅ = Wasserstoff. Alkyl. substituiertes Alkyl. Phenyl, substituiertes Phenyl. Halogen, Amino. Alkylamino. Dialkylamino. Hydroxy, Alkoxy, Carboxy. Carboxyalkyl, Alkoxycarbonyl, Aminocarbonyl. R₁₆-CONH- mit R₁₆ = Wasserstoff, Alkyl, substituiertes Alkyl, Phenyl oder substituiertes Phenyl, wobei R₁₃, R₁₄ und R₁₅ gleich oder unterschiedlich und Teil eines an den Thiazolring kondensierten homo- oder heterocyclischen Ringes sein können,
als haftvermittelnde Verbindung ausgewählt wird.

9. Verfahren nach einem der Ansprüche 5 bis 8, **dadurch gekennzeichnet, daß** mindestens ein Thiazol aus der Gruppe, bestehend aus Aminothiazol und substituierten Aminothiazoien, als haftvermittelnde Verbindung ausgewählt wird.

10. Verfahren nach einem der Ansprüche 5 bis 9, **dadurch gekennzeichnet, daß** mindestens ein Thiadiazol aus der Gruppe, bestehend aus Aminothiadiazol und substituierten Aminothiadiazolen, als haftvermittelnde Verbindung ausgewählt wird.

11. Verfahren nach einem der vorstehenden Ansprüche, **dadurch gekennzeichnet, daß** mindestens ein Sulfoniumsalz aus der Gruppe, bestehend aus Trimethylsulfoniumsalzen, Triphenylsulfoniumsalzen, Methioninalkylsulfoniumsalzen und Methioninbenzylsulfoniumsalzen, als haftvermittelnde Verbindung ausgewählt wird.

12. Verfahren nach einem der vorstehenden Ansprüche, **dadurch gekennzeichnet, daß** mindestens eine Verbindung aus der Gruppe, bestehend aus Triazolen, Tetrazolen, Imidazolen, Pyrazolen und Purinen, als Stickstoff enthaltende, fünfgliedrige heterocyclische Verbindung ausgewählt wird.

13. Verfahren nach Anspruch 12, **dadurch gekennzeichnet, daß** mindestens ein Triazol mit der chemischen Formel **E1** 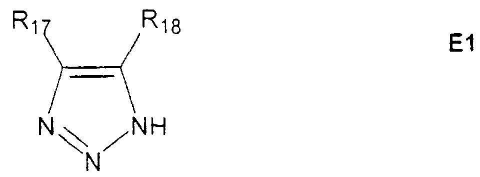
mit R₁₇, R₁₈ = Wasserstoff, Alkyl, substituiertes Alkyl, Amino, Phenyl, substituiertes Phenyl, Carboxyalkyl, wobei R₁₇ und R₁₈ gleich oder unterschiedlich und Teil eines an den Triazolring kondensierten homo- oder heterocyclischen Ringes sein können,
als Stickstoff enthaltende, fünfgliedrige heterocyclische Verbindung ausgewählt wird.

14. Verfahren nach einem der Ansprüche 12 und 13, **dadurch gekennzeichnet, daß** mindestens ein Triazol aus der Gruppe, bestehend aus Benzotriazol, Methylbenzotriazol, Ethylbenzotriazol und Dimethylbenzotriazol, als Stickstoff enthaltende, fünfgliedrige heterocyclische Verbindung ausgewählt wird.

15. Verfahren nach einem der Ansprüche 12 bis 14, **dadurch gekennzeichnet, daß** mindestens ein Tetrazol mit der chemischen Formel **E2** 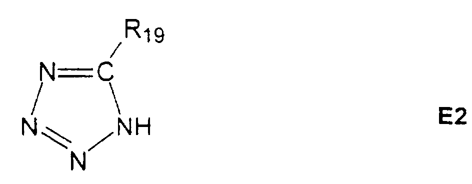
mit R₁₉ = Wasserstoff, Alkyl, substituiertes Alkyl, Halogenalkyl, Amino, Phenyl, substituiertes Phenyl, Benzyl, Carboxy, Carboxyalkyl, Alkoxycarbonyl, Aminocarbonyl oder R₂₀-CONH mit R₂₀ = Wasserstoff, Alkyl, substituiertes Alkyl, Phenyl oder substituiertes Phenyl
als Stickstoff enthaltende, fünfgliedrige heterocyclische Verbindung ausgewählt wird.

16. Verfahren nach einem der Ansprüche 12 bis 15, **dadurch gekennzeichnet, daß** mindestens ein Tetrazol aus der Gruppe, bestehend aus 5-Aminotetrazol und 5-Phenyltetrazol, als Stickstoff enthaltende, fünfgliedrige heterocyclische Verbindung ausgewählt wird.

17. Verfahren nach einem der vorstehenden Ansprüche, **dadurch gekennzeichnet, daß** für Komponente b. in der ersten Lösung Schwefelsäure als Säure ausgewählt wird.

18. Anwendung des Verfahrens nach einem der Ansprüche 1 bis 17 zum Vorbehandeln von Kupferschichten aufweisenden Leiterplatteninnenlagen zum Bilden eines haftfesten Verbundes zwischen den Leiterplatteninnenlagen und Kunstharzlagen.

19. Anwendung des Verfahrens nach einem der Ansprüche 1 bis 17 zum Vorbehandeln von Kupferschichten aufweisenden Leiterplatten zum Bilden eines haftfesten Verbundes zwischen den Kupferschichten und aus Kunststoffen bestehenden Resisten.

## Claims

1. Method for the preliminary treatment of copper surfaces for the subsequent formation of a firmly adhesive bonding between the copper surfaces and plastics material substrates by bringing the copper surfaces into contact with a first solution, containing
a. hydrogen peroxide,
b. at least one acid and
c. at least one nitrogen-containing, five-membered, heterocyclic compound which has no sulphur atom, no selenium atom or tellurium atom in the heterocycle,
**characterised in that**
the copper surfaces are then brought into contact with a second solution, containing
d. at least one bonding compound from the group of sulphinic acids, selenic acids, telluric acids, heterocyclic compounds which contain at least one sulphur, selenium and/or tellurium atom in the heterocycle, as well as sulphonium, selenonium and telluronium salts, the sulphonium, selenonium and telluronium salts being compounds having the general formula A 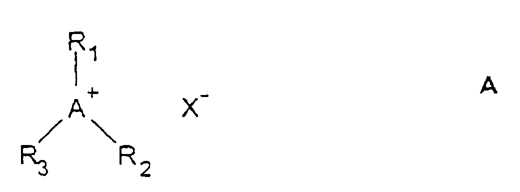 in which A = S, Se or Te,
A = S, Se oder Te,
R₁, R₂ and R₃ = alkyl, substituted alkyl, alkenyl, phenyl, substituted phenyl, benzyl, cycloalkyl, substituted cycloalkyl,
R₁, R₂ and R₃ being identical or different, and X⁻ = anion of an inorganic or organic acid or hydroxide.

2. Method according to claim 1, **characterised in that** sulphinic acids are selected as the bonding compounds from the group of aromatic sulphinic acids and compounds having the chemical formula B 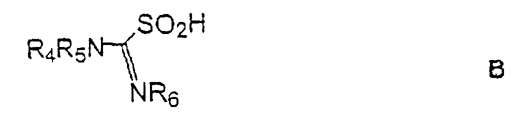 with R₄, R₅ and R₆ = hydrogen, alkyl, substituted alkyl, phenyl, substituted phenyl, R₇-(CO)- with R₇ = hydrogen, alkyl, substituted alkyl, phenyl or substituted phenyl, R₄, R₅ and R₆ being identical or different.

3. Method according to one of the preceding claims, **characterised in that** formamidine sulphinic acid is selected as the bonding compound.

4. Method according to one of claims 1 and 2, **characterised in that** aromatic sulphinic acids are selected as the bonding compounds from the group of benzene sulphinic acid, toluene sulphinic acids, chlorobenzene sulphinic acids, nitrobenzene sulphinic acids and carboxybenzene sulphinic acids.

5. Method according to one of the preceding claims, **characterised in that** at least one heterocyclic compound is selected as the bonding compound from the group of thiophenes, thiazols, isothiazols, thiadiazols and thiatriazols.

6. Method according to claim 5, **characterised in that** at least one thiophene is selected as the bonding compound from the group of compounds having the chemical formula C 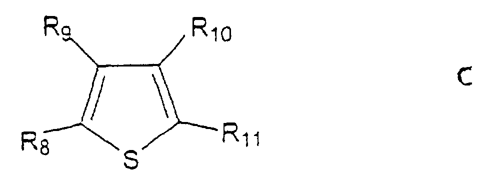
with R₈, R₉, R₁₀, R₁₁= hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl, R₁₂-CONH- with R₁₂ = hydrogen, alkyl, substituted alkyl, phenyl or substituted phenyl, R₈, R₉, R₁₀ and R₁₁ being able to be identical or different and part of homo- or heterocyclic rings condensed on the thiophene ring.

7. Method according to one of claims 5 and 6, **characterised in that** at least one thiophene is selected as the bonding compound from the group of aminothiophene carboxylic acids, esters thereof and amides thereof.

8. Method according to one of claims 5 to 7, **characterised in that** at least one thiazol is selected as the bonding compound from the group of compounds having the chemical formula D 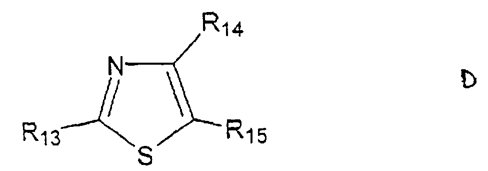
with R₁₃, R₁₄, R₁₅= hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl, R₁₆-CONH- with R₁₆ = hydrogen, alkyl, substituted alkyl, phenyl or substituted phenyl, R₁₃, R₁₄, and R₁₅ being able to be identical or different and part of a homo- or heterocyclic ring condensed on the thiazol ring.

9. Method according to one of claims 5 to 8, **characterised in that** at least one thiazol is selected as the bonding compound from the group of aminothiazol and substituted aminothiazols.

10. Method according to one of claims 5 to 9, **characterised in that** at least one thiadiazol is selected as the bonding compound from the group of aminothiadiazol and substituted aminothiadiazols.

11. Method according to one of the preceding claims, **characterised in that** at least one sulphonium salt is selected as the bonding compound from the group of trimethyl sulphonium salts, triphenyl sulphonium salts, methionine alkyl sulphonium salts and methionine benzyl sulphonium salts.

12. Method according to one of the preceding claims, **characterised in that** at least one compound is selected as the nitrogen-containing, five-membered, heterocyclic compound from the group of triazols, tetrazols, imidazols, pyrazols and purines.

13. Method according to claim 12, **characterised in that** at least one triazol is selected as the nitrogen-containing, five-membered, heterocyclic compound, having the chemical formula E1 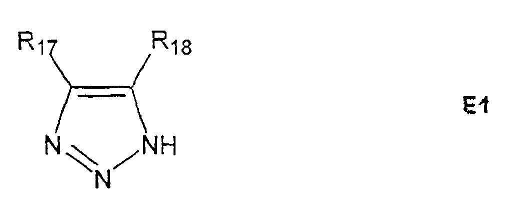
with R₁₇, R₁₈ = hydrogen, alkyl, substituted alkyl, amino, phenyl, substituted phenyl, carboxyalkyl, R₁₇ and R₁₈ being able to be identical or different and part of a homo- or heterocyclic ring condensed on the triazol ring.

14. Method according to one of claims 12 and 13, **characterised in that** at least one triazol is selected as the nitrogen-containing, five-membered, heterocyclic compound from the group of benzotriazol, methyl benzotriazol, ethyl benzotriazol and dimethyl benzotriazol.

15. Method according to one of claims 12 to 14, **characterised in that** at least one tetrazol is selected as the nitrogen-containing, five-membered, heterocyclic compound, having the chemical formula E2 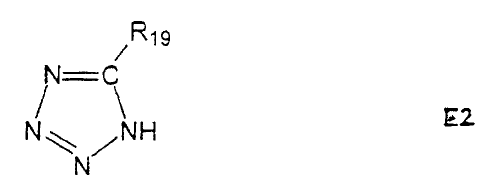
with R₁₉ = hydrogen, alkyl, substituted alkyl, halogen alkyl, amino, phenyl, substituted phenyl, benzyl, carboxy, carboxyalkyl, alkoxycarbonyl, aminocarbonyl, or R₂₀-CONH- with R₂₀ = hydrogen, alkyl, substituted alkyl, phenyl or substituted phenyl.

16. Method according to one of claims 12 to 15, **characterised in that** at least one tetrazol is selected as the nitrogen-containing, five-membered, heterocyclic compound from the group of 5-aminotetrazol and 5-phenyltetrazol.

17. Method according to one of the preceding claims, **characterised in that** sulphuric acid is selected as the acid for component b. in the first solution.

18. Use of the method according to one of claims 1 to 17 for the preliminary treatment of printed circuit board inner layers, which have copper layers, for the formation of a firmly adhesive bonding between the printed circuit inner layers and synthetic resin layers.

19. Use of the method according to one of claims 1 to 17 for the preliminary treatment of printed circuit boards, which have copper layers, for the formation of a firmly adhesive bonding between the copper layers and resists formed from plastics materials.

## Revendications

1. Procédé pour le prétraitement de surfaces de cuivre, dans le but de former après-coup un composite adhérent entre les surfaces de cuivre et des substrats plastiques, par mise en contact des surfaces de cuivre avec une première solution contenant
a. du peroxyde d'hydrogène,
b. au moins un acide, et
c. au moins un composé hétérocyclique azoté à cinq chaînons ne contenant pas d'atome de soufre, de sélénium ou de tellure dans la structure hétérocyclique,
**caractérisé en ce que**
les surfaces de cuivre sont ensuite mises en contact avec une deuxième solution contenant
d. au moins un composé promoteur d'adhérence choisi dans l'ensemble comprenant les acides sulfiniques, les acides séléniques, les acides telluriques, les composés hétérocycliques contenant au moins un atome de soufre, de sélénium et/ou de tellure dans la structure hétérocyclique, ainsi que des sels de sulfonium, de sélénonium et de telluronium, où les sels de sulfonium, de sélénonium et de telluronium sont des composés de formule générale A 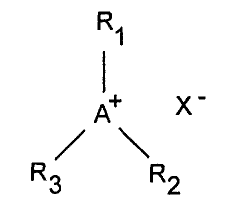
dans laquelle A est S, Se ou Te,
R₁, R₂ et R₃ sont des groupes alkyle, alkyle substitué, alcényle, phényle, phényle substitué, benzyle, cycloalkyle, cycloalkyle substitué, R₁, R₂ et R₃ étant identiques ou différents, et
X⁻ est l'anion d'un acide inorganique ou organique ou l'anion hydroxyde.

2. Procédé selon la revendication 1, **caractérisé en ce que** l'on choisit en tant que composés promoteurs d'adhérence des acides sulfiniques choisis dans l'ensemble comprenant les acides sulfiniques aromatiques et les composés ayant la formule chimique B 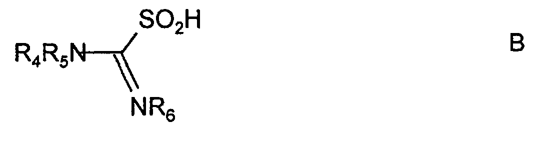 dans laquelle R₄, R₅ et R₆ sont des atomes d'hydrogène, des groupes alkyle, alkyle substitué, phényle, phényle substitué, R₇-(CO)- où R₇ est un atome d'hydrogène, un groupe alkyle, alkyle substitué, phényle ou phényle substitué, R₄, R₅ et R₆ étant identiques ou différents.

3. Procédé selon l'une des revendications précédentes, **caractérisé en ce qu'**on choisit en tant que composé promoteur d'adhérence l'acide formamidinesulfonique.

4. Procédé selon l'une des revendications 1 et 2, **caractérisé en ce qu'**on choisit en tant que composés promoteurs d'adhérence des acides sulfiniques aromatiques choisis dans l'ensemble comprenant l'acide benzènesulfinique, les acides toluènesulfiniques, les acides chlorobenzènesulfiniques, les acides nitrobenzènesulfiniques et les acides carboxybenzènesulfiniques.

5. Procédé selon l'une des revendications précédentes, **caractérisé en ce qu'**on choisit en tant que composé promoteur d'adhérence au moins un composé hétérocyclique choisi dans l'ensemble comprenant les thiophènes, les thiazoles, les isothiazoles, les thiadiazoles et les thiatriazoles.

6. Procédé selon la revendication 5, **caractérisé en ce qu'**on choisit en tant que composé promoteur d'adhérence au moins un thiophène choisi dans l'ensemble comprenant les composés ayant la formule chimique C 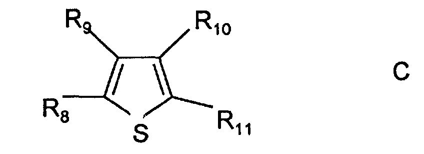 dans laquelle R₈, R₉, R₁₀ et R₁₁ sont des atomes d'hydrogène, des groupes alkyle, alkyle substitué, phényle, phényle substitué, halogéno, amino, alkylamino, dialkylamino, hydroxy, alcoxy, carboxy, carboxyalkyle, alcoxycarbonyle, aminocarbonyle, R₁₂-CONH- où R₁₂ est un atome d'hydrogène, un groupe alkyle, alkyle substitué, phényle ou phényle substitué, où R₈, R₉, R₁₀ et R₁₁ peuvent être identiques ou différents et former une partie de noyaux homo- ou hétérocycliques condensés au noyau thiophène.

7. Procédé selon l'une des revendications 5 et 6, **caractérisé en ce qu'**on choisit en tant que composé promoteur d'adhérence au moins un thiophène choisi dans l'ensemble comprenant les acides aminothiophènecarboxyliques, leurs esters et leurs amides.

8. Procédé selon l'une des revendications 5 à 7, **caractérisé en ce qu'**on choisit en tant que composé promoteur d'adhérence au moins un thiazole choisi dans l'ensemble comprenant les composés ayant la formule chimique D 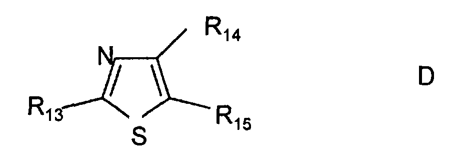 dans laquelle R₁₃, R₁₄, R₁₅ sont des atomes d'hydrogène ou des groupes alkyle, alkyle substitué, phényle, phényle substitué, halogéno, amino, alkylamino, dialkylamino, hydroxy, alcoxy, carboxy, carboxyalkyle, alcoxycarbonyle, aminocarbonyle, R₁₆-CONH- où R₁₆ est un atome d'hydrogène, un groupe alkyle, alkyle substitué, phényle ou phényle substitué, où R₁₃, R₁₄ et R₁₅ peuvent être identiques ou différents et représenter une partie d'un noyau homo- ou hétérocyclique condensé au noyau thiazole.

9. Procédé selon l'une des revendications 5 à 8, **caractérisé en ce qu'**on choisit en tant que composé promoteur d'adhérence au moins un thiazole choisi dans l'ensemble comprenant l'aminothiazole et les aminothiazoles substitués.

10. Procédé selon l'une des revendications 5 à 9, **caractérisé en ce qu'**on choisit en tant que composé promoteur d'adhérence au moins un thiadiazole choisi dans l'ensemble comprenant l'aminothiadiazole et les aminothiadiazoles substitués.

11. Procédé selon l'une des revendications précédentes, **caractérisé en ce qu'**on choisit en tant que composé promoteur d'adhérence au moins un sel de sulfonium choisi dans l'ensemble comprenant les sels de triméthylsulfonium, les sels de triphénylsulfonium, les sels de méthioninalkylsulfonium et les sels de méthioninebenzylsulfonium.

12. Procédé selon l'une des revendications précédentes, **caractérisé en ce qu'**on choisit en tant que composé hétérocyclique azoté à cinq chaînons au moins un composé choisi dans l'ensemble comprenant les triazoles, les tétrazoles, les imidazoles, les pyrazoles et les purines.

13. Procédé selon la revendication 12, **caractérisé en ce qu'**on choisit en tant que composé hétérocyclique azoté à cinq chaînons au moins un triazole ayant la formule chimique E1 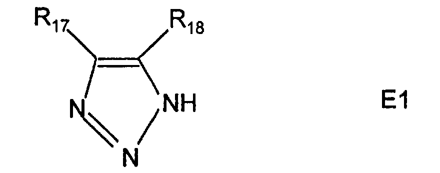 dans laquelle R₁₇ et R₁₈ sont des atomes d'hydrogène, des groupes alkyle, alkyle substitué, amino, phényle, phényle substitué, carboxyalkyle, où R₁₇ et R₁₈ peuvent être identiques ou différents et représenter une partie d'un noyau homo- ou hétérocyclique condensé sur le noyau triazole.

14. Procédé selon l'une des revendications 12 et 13, **caractérisé en ce qu'**on choisit en tant que composé hétérocyclique azoté à cinq chaînons au moins un triazole choisi dans l'ensemble comprenant le benzotriazole, le méthylbenzotriazole, l'éthylbenzotriazole et le diméthylbenzotriazole.

15. Procédé selon l'une des revendications 12 à 14, **caractérisé en ce qu'**on choisit en tant que composé hétérocyclique azoté à cinq chaînons au moins un tétrazole ayant la formule chimique E2 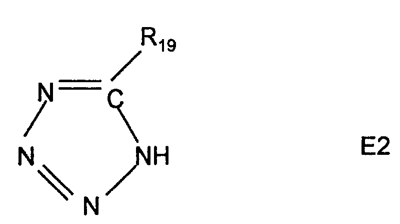 dans laquelle R₁₉ est un atome d'hydrogène, un groupe alkyle, alkyle substitué, halogènalkyle, amino, phényle, phényle substitué, benzyle, carboxy, carboxyalkyle, alcoxycarbonyle, aminocarbonyle ou R₂₀-CONH où R₂₀ est un atome d'hydrogène, un groupe alkyle, alkyle substitué, phényle ou phényle substitué.

16. Procédé selon l'une des revendications 12 à 15, **caractérisé en ce qu'**on choisit en tant que composé hétérocyclique azoté à cinq chaînons au moins un tétrazole choisi dans l'ensemble comprenant le 5-aminotétrazole et le 5-phényltétrazole.

17. Procédé selon l'une des revendications précédentes, **caractérisé en ce qu'**on choisit en tant qu'acide pour le composé b de la première solution l'acide sulfurique.

18. Utilisation du procédé selon l'une des revendications 1 à 17 pour le prétraitement de couches intérieures de cartes imprimées comportant des couches de cuivre, dans le but de former un composite adhérent entre les couches intérieures des plaques imprimées et des couches en une résine synthétique.

19. Utilisation du procédé selon l'une des revendications 1 à 17 pour le prétraitement de cartes imprimées comportant des couches de cuivre, pour former un composite adhérent entre les couches de cuivre et les réserves constituées de matériaux plastiques.
